# EUROPÄISCHE PATENTANMELDUNG

(11) **EP 3 609 306 A2**
(43) Veröffentlichungstag der Anmeldung: **12.02.2020**
(21) Anmeldenummer: 19184285.5
(22) Anmeldetag: 04.07.2019
(51) Int. Cl.: H05K 7/20

(54) **STEUERGERÄT FÜR EIN FAHRZEUG**

(30) Priorität: 19.07.2018 DE 102018212076
(71) Anmelder: ZF Friedrichshafen AG, 88046 Friedrichshafen (DE)
(72) Erfinder: Rakoczi, Viktor, 88090 Immenstaad am Bodensee (DE); Keckeisen, Michael, 88074 Meckenbeuren (DE); Briemle, Oliver, 88048 Friedrichshafen (DE); Vieweger, Wolfgang, 88085 Langenargen (DE)

(57) **Zusammenfassung**

Es wird ein Steuergerät (SG) für ein Fahrzeug (V) vorgeschlagen, das wenigstens einen Elektronikbaustein (GPU) aufweist. Weiterhin ist wenigstens ein erster Lüfter (F1) vorgesehen und ein Luftkanal (LK), der einen Luftstrom (LS) von einer ersten Seite des wenigstens einen Elektronikbausteins (GPU) zum ersten Lüfter (F1) ermöglicht, wobei der Luftstrom (LS) weiter nach dem ersten Lüfter an einer zweiten Seite des wenigstens einen Elektronikbausteins (GPU) vorbeiströmt.

## Beschreibung

Die Erfindung betrifft ein Steuergerät für ein Fahrzeug nach der Gattung des unabhängigen Patentanspruchs.

Das erfindungsgemäße Steuergerät für ein Fahrzeug mit den Merkmalen des unabhängigen Patentanspruchs hat den Vorteil, dass ein Luftkanal vorgesehen ist, der einen Luftstrom von einer ersten Seite eines Elektronikbausteins, beispielsweise eines Prozessors, zum Lüfter ermöglicht, wobei der Luftstrom weiter an eine zweite Seite des Elektronikbausteins vorbeiströmt. Dadurch ist eine beidseitige Kühlung des Elektronikbausteins möglich. Die erfindungsgemäße Lösung hat wenig Bauraumbedarf, insbesondere ist auch eine gezielte Lüftung von sogenannten Heatspots (Wärmezentren) möglich. Die geschlossene Luftzirkulation innerhalb des Steuergeräts ermöglicht eine gute thermische Anbindung an das Steuergerätgehäuse selbst. Außerdem ist mit dem erfindungsgemäßen Steuergerät ein dicht abschließbares Steuergerät ohne großen Aufwand realisierbar, da sich dieses Kühlkonzept nur innerhalb des Steuergeräts selbst befindet. Das erfindungsgemäße Steuergerät weist weiterhin eine wartungsfreie Kühlung auf, da keine Schmutzpartikel vorhanden sind und das Steuergerät hermetisch abgedichtet ist. Auch eine Minimierung der Emission von hörbarem Schall durch den Lüfter ist durch die Dichtigkeit des Steuergeräts zu erwarten. Außerdem ist das Produkt in sich geschlossen, sodass ein sogenanntes Stand-Alone-Produkt vorliegt.

Das erfindungsgemäße Steuergerät für ein Fahrzeug hat also wenigstens einen Elektronikbaustein, wenigstens einen Lüfter, einen Luftkanal, der einen Luftstrom von einer ersten Seite des wenigstens einen Elektronikbausteins zum Lüfter ermöglicht, wobei der Luftstrom weiter, vorzugsweise nach diesem Lüfter, an eine zweite Seite des wenigstens einen Elektronikbausteins vorbeiströmt.

Unter einem Steuergerät ist vorliegend insbesondere ein Steuergerät mit einem Gehäuse, beispielsweise aus Metall oder Kunststoff oder eine Verbindung daraus, zu verstehen, in dem sich wenigstens ein Prozessor als ein Elektronikbaustein befindet. Insbesondere ist vorgesehen, dass dieses Steuergerät mehrere Prozessoren, beispielsweise sogenannte Grafikprozessoren aufweist, um verschiedene Funktionen aus den Sensorsignalen, die an das Steuergerät geleitet werden, abzuleiten. Insbesondere kann dafür eine sogenannte künstliche Intelligenz verwendet werden, die die Sensordaten mittels der grafischen Grafikprozessoren durch neuronale Netzwerke auswertet, um Steuersignale zu erzeugen, die zu den Fahrzeugsystemen für deren Ansteuerung geleitet werden.

Unter einem Fahrzeug wird beispielsweise ein Personenkraftwagen, aber auch ein Lkw oder jedes andere Fahrzeug bspw. auch fahrerlose Fahrzeuge in Logistikzentren verstanden.

Wie oben bereits angegeben, kann unter dem wenigstens einen Elektronikbaustein insbesondere ein Prozessor, vorzugsweise ein Grafikprozessor, verstanden werden. Es sind jedoch auch andere Elektronikbausteine möglich, die gekühlt werden müssen. Prozessoren müssen aufgrund ihrer hohen Rechenleistung und der entsprechenden Wärmeabgabe eine Kühlung aufweisen.

Unter einem Lüfter wird ein Ventilator verstanden, der gemäß den abhängigen Ansprüchen auch noch weiter definiert wird. Dieser Lüfter hat die Aufgabe, einen Luftstrom zu erzeugen, der entweder angesogen wird oder geblasen wird, und dafür können entsprechende Technologien verwendet werden.

Unter dem Luftkanal wird eine bauliche Maßnahme verstanden, die geeignet ist, den Luftstrom von der ersten Seite des Elektronikbausteins zum Lüfter zu ermöglichen. Dafür kann der Luftkanal als Schlauch mit rundem Querschnitt oder auch als Kanal mit eckigem Querschnitt vorgesehen sein. Als Materialien könnte Kunststoff verwendet werden, aber auch Metall oder Verbindungen daraus. Jedes andere geeignete Material kann vorliegend verwendet werden. Der Luftkanal sollte einen konstanten Querschnitt über die gesamte Länge aufweisen und möglichst keine Sprünge oder Ecken, sondern einen kontinuierlichen Verlauf. Der Luftkanal ist möglichst nahe über dem Elektronikbaustein zu platzieren.

Unter dem Luftstrom ist dann jene bewegte Luft zu verstehen, die durch den Lüfter beispielsweise angesogen wird.

Unter der ersten und zweiten Seite des Elektronikbausteins ist beispielsweise die Ober- und die Unterseite zu verstehen, wobei auch andere Baugruppen dazwischen sein können, d.h. der Luftstrom muss nicht unmittelbar mit dem Elektronikbaustein in Verbindung stehen, es können auch andere Bausteine zwischen dem Luftstrom und dem Elektronikbaustein vorgesehen sein. Die Idee ist, dass die Wärme vom Elektronikbaustein auf diese weiteren Bausteine weitergeleitet wird und die Wärme dann dort abtransportiert wird.

Durch die in den abhängigen Ansprüchen aufgeführten Maßnahmen und Weiterbildungen sind vorteilhafte Verkörperungen des im unabhängigen Patentanspruch angegebenen Steuergeräts für ein Fahrzeug möglich.

Es ist vorteilhafterweise vorgesehen, dass wenigstens ein erstes Wärmerohr (Heatpipe) im Bereich des Luftstroms an der zweiten Seite des wenigstens einen Elektronikbausteins vorgesehen ist. Dadurch kann der Luftstrom durch dieses Wärmerohr abgekühlt werden. Unter einem Wärmerohr ist vorliegend eine sogenannte Heatpipe zu verstehen. Ein Wärmerohr ist ein Wärmeübertrager, der unter Nutzung von Verdampfungswärme eines Mediums eine hohe Wärmestromdichte erlaubt. Das heißt, auf kleiner Querschnittsfläche können große Wärmemengen transportiert werden. Solche Wärmerohre enthalten grundsätzlich ein hermetisch gekapseltes Volumen, meist in Form eines Rohres. Dieses ist mit einem Arbeitsmedium, z.B. Wasser oder Ammoniak gefüllt, welches das Volumen zu einem kleinen Teil im flüssigen, zum größeren Teil im dampfförmigen Zustand ausfüllt. Darin befindet sich je eine Wärmeübertragungsfläche für Wärmequelle und -senke.

Bei Wärmeeintrag beginnt das Arbeitsmedium zu verdampfen. Dadurch wird über dem Flüssigkeitsspiegel der Druck im Dampfraum lokal erhöht, was zu einem geringen Druckgefälle innerhalb des Wärmerohrs führt. Der entstandene Dampf strömt deswegen zu einer Stelle mit niedriger Temperatur, wo er kondensiert. An dieser Stelle erhöht sich die Temperatur durch die frei werdende Kondensationswärme. Die zuvor aufgenommene latente Wärme wird an die Umgebung abgegeben. Das nun flüssige Arbeitsmedium kehrt durch Schwerkraft bzw. durch Kapillarkräfte im Fall der Heatpipe wieder zurück zu der Stelle, an der die Wärme eingeleitet wird.

Da sich Dampf und Flüssigkeit des Fluids im selben Raum aufhalten, befindet sich das System im Nassdampfgebiet. Das hat zur Folge, dass bei einem bestimmten Druck im Wärmerohr exakt eine bestimmte Temperatur vorliegt. Da die Druckunterschiede in Wärmerohren mit meist wenigen Pascal sehr gering sind, ist die sich einstellende Temperaturdifferenz zwischen Verdampfer und Kondensator auch gering und beträgt maximal wenige Kelvin. Ein Wärmerohr besitzt daher einen sehr geringen Wärmewiderstand. Der Bereich zwischen Verdampfer und Kondensator ist praktisch isotherm.

Da der Wärmetransport indirekt über den stoffgebundenen Transport von latenter Wärme (Verdampfungs-Kondensationswärme) stattfindet, beschränkt sich der Einsatzbereich eines Wärmerohrs auf den Bereich zwischen der Schmelztemperatur und der Temperatur des kritischen Punkts des Arbeitsfluids. Alle Kräfte, die auf das Arbeitsmedium wirken, beeinflussen zudem die tatsächliche Wärmetransportleistung. Die Schwerkraft kann die Kapillarkräfte in Heatpipes ergänzen oder teilweise aufheben.

Es ist weiterhin vorteilhafterweise vorgesehen, dass an der ersten Seite des wenigstens einen Elektronikbausteins wenigstens ein zweites Wärmerohr bzw. Heatpipe vorgesehen ist.

Es ist weiterhin vorgesehen, dass zwischen dem wenigstens einen Elektronikbaustein und jeweils dem ersten und dem zweiten Wärmerohr ein sogenanntes Thermal Interface Material (TIM) insbesondere ein Gapfiller angeordnet ist. Alternativ zu dem Gapfiller kann auch eine sogenannte Wärmeleitfolie eingesetzt werden. Sie erfüllt den gleichen Zweck und zeigt Vorteile hinsichtlich der Verarbeitung. Ein Gapfiller ist meistens eine pastenartige Masse mit Silberpartikeln, um die Wärmeleitfähigkeit zu steigern.

Ein TIM hat den Zweck des Wärmetransports. Dieser Wärmetransport soll zwischen zwei flächig bündig zu fixierenden Flächen geschehen. Außerdem soll der Gapfiller den Ausgleich von mechanischen Toleranzen erreichen. Weiterhin ist eine abschließende Funktion vorgesehen, eine sogenannte Hermetizität.

Der Gapfiller oder aber auch eine Wärmeleitfolie werden nicht nur in dem oben genannten Aufbau eingesetzt, sondern auch beim Zusammenfügen des aus zwei oder mehr Teilen bestehenden Steuergerät-Gehäuses, bspw. einer Oberschale oder einer Unterschale.

Es wird vorteilhafterweise vorgesehen, das Innere des hermetisch verdichteten Steuergeräts mit Stickstoff zu befüllen. Dies kann mit einem gewissen Überdruck geschehen. Die so gebildete Stickstoffatmosphäre verhindert ein Beschlagen des Inneren bei kalten Temperaturen oder bei schnellen Temperaturwechseln.

Weiterhin ist es vorteilhaft, dass der wenigstens eine Elektronikbaustein auf einer sogenannten Performanceplatine (Performance-Board) angeordnet ist, wobei die Performanceplatine auf einer Trägerplatine angeordnet ist. Damit ist ein Aufbau möglich, der insbesondere das Unterströmen des Elektronikbausteins auf dieser Performanceplatine ermöglicht. Eine Performanceplatine ist eine Platte, die den Aufbau von elektronischen Bauelementen ermöglicht und auch die Leitungen zwischen diesen bereitstellt. Dies kann auf unterschiedlichste Weise geschehen.

Um eine Hardware-Modularität oder funktionsseitig ein skalierbares System bereitzustellen, wird das Steuergerät nach oben genannten Aufbau mit mehreren Performanceplatinen mit nahezu identischer Hardware und Software vorgeschlagen.

Es ist weiterhin vorgesehen, dass mehrere Perfomanceplatinen, die auf der Trägerplatine angeordnet sind, vorgesehen sind, wobei der Luftkanal in Abhängigkeit vom jeweiligen Elektronikbaustein gestaltet ist, um einen entsprechenden Luftstrom zu erzeugen. Damit liegt eine Struktur vor, auf der beispielsweise mehrere Prozessoren, die auf jeweiligen Performanceplatinen angeordnet sind, einen eigenen Lüfter aufweisen, der einen jeweiligen Luftstrom durch die Gestaltung des Luftkanals ermöglicht. Die Lüfter können identisch oder unterschiedlich sein. Bei identischen Lüftern ist der Betrieb des jeweiligen Lüfters an seine Anforderungen für die Kühlung des jeweiligen Elektronikbaustein angepasst. Es ist jedoch auch möglich, nur einen einzigen Lüfter zu verwenden, der die verschiedenen Kanäle bedient. Ein jeweils zugeordneter Lüfter hat den Vorteil, dass ein Lüfterausfall nicht zum Totalausfall des gesamten Steuergeräts führt. Damit ist es dann möglich, dass je nach Wärmeentwicklung, die erwartet wird, einen entsprechenden Luftstrom bereitzustellen, um eine optimale Kühlung zu ermöglichen.

Es ist weiterhin vorteilhafterweise vorgesehen, dass wenigstens ein zweiter Lüfter außerhalb des Gehäuses angeordnet ist, wobei das Gehäuse den Elektronikbaustein und den wenigstens ersten Lüfter und den Luftkanal umschließt. Dieser zweite Lüfter außerhalb des Gehäuses sorgt für eine weitere Kühlung, indem er die Wärme, die im Steuergerät erzeugt wird, abtransportiert.

Dafür kann das Gehäuse vorteilhafterweise außen wenigstens teilweise eine erste Rippenstruktur aufweisen. Diese geriffelte Kühlstruktur sorgt für einen effizienteren Wärmeaustausch. Die Rippen dienen dazu, den Turbulenzgrad der Strömung zu vergrößern. Dadurch wird ein Wärmestrom von innen nach außen effizienter. Um also eine Kühlung über eine erzwungene Strömung zu erreichen, ist das Vorhandensein von Turbulenzen an den Konturen des zu kühlenden Körpers notwendig. Diese Turbulenzen werden durch die Rippen oder geriffelte Kühlstruktur bzw. Rippenstruktur erreicht.

Es ist weiterhin vorteilhafterweise vorgesehen, dass das Gehäuse wenigstens teilweise innen eine zweite Rippenstruktur aufweist. Dadurch wird der gleiche Effekt auch innerhalb erzielt und der Wärmestrom von innen nach außen wird so weiterbefördert. Die Rippenstrukturen können aus Metall ausgebildet sein. Aber auch andere geeignete Materialien sind vorliegend möglich, bspw. Siliziumcarbid.

Weiterhin ist vorzugsweise vorgesehen, dass der wenigstens erste Lüfter im Steuergerät ein Radiallüfter ist und der wenigstens zweite Lüfter außen am Gehäuse ein Axiallüfter ist. Es ist jedoch auch ein sogenannter Diagonallüfter möglich, der eine Mischform der anderen beiden Typen darstellt. Bei einem Axiallüfter verläuft die Drehachse des Axiallaufrads parallel bzw. axial zum Luftstrom. Die Luft wird durch das Axiallaufrad ähnlich wie bei einem Flugzeug oder Schiffspropeller bewegt. Die Vorteile von Axiallüftem sind die im Verhältnis zum hohen geförderten Luftdurchsatz geringen Abmessungen, insbesondere die flache Bauweise. Radiallüfter saugen die Luft parallel bzw. axial zur Antriebsachse des Radiallüfters an und durch die Rotation des Radiallaufrads um 90° wird sie umgelenkt und radial ausgeblasen. Es gibt einseitig und beidseitig ansaugende Radiallüfter mit und ohne Gehäuse. Der Einsatz des Lüfters kann dem sogenannten Cordier-Diagramm entnommen werden.

Wenn man Lüfter auf Kühlkriterien beschreibt, spricht man immer von zwei gegenläufigen Größen:
Axiallüfter: hoher Volumenstrom, wenig Druckaufbau möglich
Radiallüfter: hoher Druckaufbau möglich, wenig Volumenstrom

Aufgrund der Konstruktion eines Radiallüfters, ist es vorteilhafterweise möglich, das Lüftergehäuse an die Innenseite des Steuergerätes thermisch und mechanisch anzubinden, um die vom Lüfter selbst erzeugte Wärme und die des Inneren des Steuergeräts abzuführen.

Der stehende Radiallüfter weist vorzugsweise an der radialen (Seiten-)Fläche ein Metallblech auf, das mit dem Gehäuse oberseitig verbunden ist. Der Wärmepfad ist der folgende: Die Wärme wird im Motor bzw. der Elektronik des Motors gebildet. Sie darüber an das Metallblech geleitet. Über die Anbindung an das Gehäuse wird die Wärme weiter an die umliegende Luft transportiert.

Es ist vorteilhafterweise vorgesehen, zwischen den einzelnen Performance-Boards (Perofmanceplatinen) und dem Carrierboard (Hauptplatine) unterseitig vertikal stehende Kunststoffflächen anzubringen (Wände), um unabhängige thermische "Sub-"Systeme zu haben, vor allem aber um einen stabilen Gleichgewichtszustand hinsichtlich Volumenstrom und Druckverlust zu haben. Denn insb. bei einem Lüfterausfall würde ein instabiler Volumenstrom- und Druckverlust-Zustand eintreten, und die intakten Lüfter würden nicht im spezifizierten Arbeitspunkt arbeiten. Die Wände sind daher vorzugsweise so vorgesehen, dass sie an der jeweiligen Unterseite der jeweiligen Performanceplatine angebracht sind, bspw. durch lösende oder nicht lösende Verbindungstechnik. Alternativ oder zusätzlich können diese Wände auch auf oder unter der Hauptplatine angebracht sein und dann in Richtung der Performanceplatine ragen.

Vorzugsweise werden die Kühlstrukturen (Rippenstruktur), die auf der Gehäuseinnenseite angebracht sind, in Strömungsrichtung (parallel) angeordnet, um eine Luftzirkulation zu gewährleisten.

Die hier zugrundeliegende Erfindung bietet den Vorteil, dass nicht nur ein einziger dominanter Wärmepfad vorliegt, sondern die Wärme kann über fast allen sechs Seiten des Gehäuses abgeführt werden. Das ist eine effiziente Kühlung des Steuergeräts.

Zugrundeliegender Erfindung ist es möglich, die auf dem Performance-Board oberseitig und unterseitig angebrachten wärmeabgebenden Bauteile gezielt, je nachdem wo die Öffnung des Luftkanals ist, zu kühlen.

Der Luftkanal saugt die Luft von der Performance-Board Oberseite Luft an und bläst die Luft weiter in die Kühlstruktur, welche zwischen der Performance-Board und Main-Board angebracht ist, weiter. Am Ausgang der Kühlstruktur findet der Austausch zum Gehäuse statt. Es wird vorteilhafterweise somit der luftsaugende, aber auch der luftblasende Anteil des Lüfters zur Kühlung verwendet.

Ausführungsbeispiele der Erfindung sind in der Zeichnung dargestellt und werden in der nachfolgenden Beschreibung näher erläutert.

Es zeigen
Fig. 1 ein Blockschaltbild des erfindungsgemäßen Steuergeräts im Fahrzeug mit angeschlossenen Geräten,
Fig. 2 eine Darstellung des erfindungsgemäßen Steuergeräts mit einer Ausführung eines Luftkanals und einer äußeren Kühlung sowie
Fig. 3 eine Darstellung des Steuergeräts mit mehreren Elektronikbausteinen auf verschiedenen Performanceplatinen.

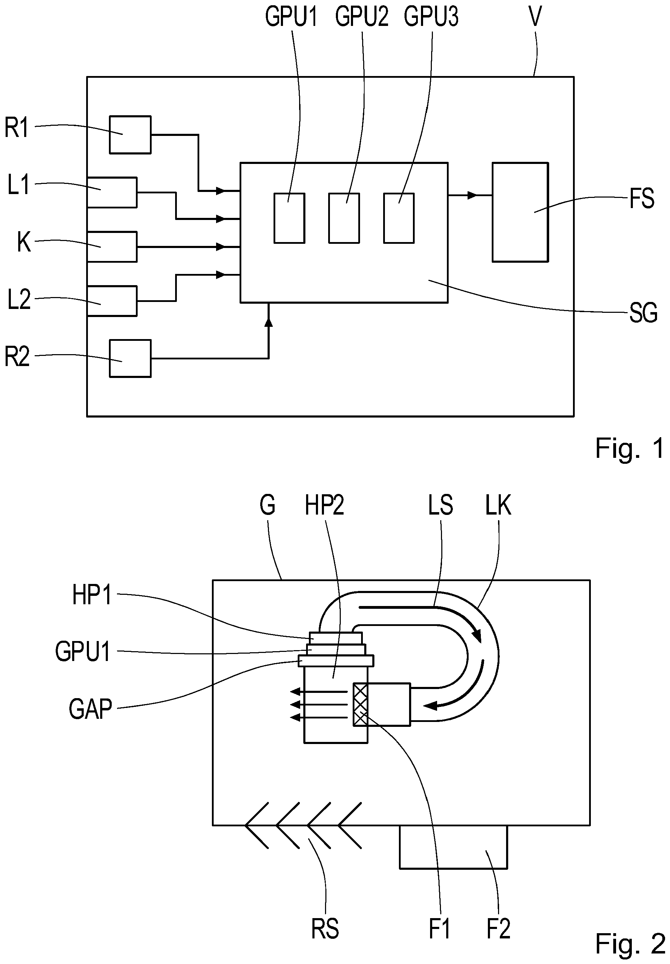

Fig. 1 zeigt in einem Blockschaltbild das erfindungsgemäße Steuergerät SG mit angeschlossenen Sensoren, Radarsensoren R1 und R3, Lidarsensoren L1 und L2 sowie einer Kamera K. Es sind mehr oder weniger Sensoren gleicher oder verschiedener Art weiterhin anschließbar. Diese Sensordaten werden vorliegend beispielsweise von drei Grafikprozessoren GPU1, GPU2 und GPU3 im Steuergerät SG ausgewertet. Mit dem Auswerteergebnis wird dann beispielsweise ein Fahrzeugsteller FS angesteuert. Dies kann eine Lenkung, ein Bremssystem, ein Getriebe, ein Gaspedal, eine Anzeige, ein Audiosystem oder andere Fahrzeugsysteme sein.

Fig. 2 zeigt das Steuergerät SG mit einem beispielhaften Innenleben. Ein Gehäuse G weist eine innere und äußere Rippenstruktur RS auf, die teilweise das Gehäuse einnimmt. Diese äußere und innere Rippenstruktur RS erzeugt wie oben dargestellt Turbulenzen aufgrund der Verwendung des Lüfters F2. Dies sorgt für einen Wärmetransport aus dem Steuergerät heraus. Im Gehäuse des Steuergeräts G ist beispielhaft eine Struktur mit einem Grafikprozessor GPU1 als Elektronikbaustein vorgestellt. Der Grafikprozessor GPU1 ist von einer Heatpipe HP1 abgedeckt, an die ein Luftkanal LK angeschlossen ist. Unter dem Grafikprozessor GPU1 befindet sich ein sogenannter Gapfiller GAP, der die Verbindung zur Heatpipe HP2 darstellt. Der Luftkanal führt nun einen Luftstrom LS, der durch den Lüfter F1 am Ende des Luftkanals bewirkt wird, zu der Heatpipe HP2. Dadurch kann der Luftstrom durch die Heatpipe HP2 weiter gekühlt werden.

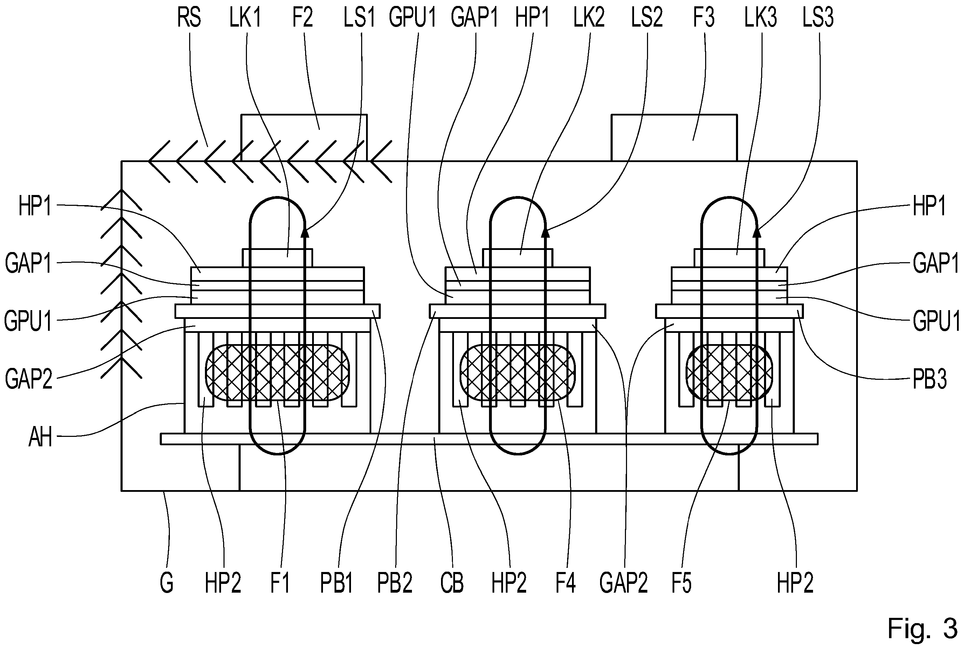

Fig. 3 zeigt erneut das Gehäuse G mit einer inneren und äußeren Rippenstruktur RS. Außerhalb des Steuergeräts am Gehäuse G sind zwei Lüfter F2 und F3 angeordnet, um mittels der Rippenstruktur RS den Wärmetransport wie oben dargestellt aus dem Gehäuse des Steuergeräts nach außen zu bewirken. Innerhalb des Gehäuses G befinden sich drei Strukturen mit Grafikprozessoren GPU1, die jeweils von einem Gapfiller GAP1 nach oben abgedeckt sind auf dem sich dann wiederum eine Heatpipe HP1 jeweils anschließt. Über der Heatpipe ist ein jeweiliger Luftkanal LK1, LK2 und LK3 vorgesehen. Unter den Grafikprozessoren GPU1 ist jeweils ein Performance-Board PB1, PB2 und PB3 vorgesehen. Unter dem Performance-Board befindet sich wiederum ein Gapfiller GAP2, an den sich die Heatpipe HP2 nach unten anschließt. Jede der drei Strukturen hat jeweils einen Lüfter F1, F4 und F5, die jedoch unterschiedliche Luftströme LS1, LS2 und LS3 je nach Hitzeentwicklung entwickeln. Dies könnte über eine Sensorik auch adaptiv ausgelegt sein. Die Performance-Boards PB1, PB2 und PB3 sind über Abstandshalter AH auf dem sogenannten Carrier-Board angeordnet. Dies ist mit CB bezeichnet.

### Bezugszeichen

- V: Fahrzeug
- L1, L2: Lidar
- R1, R2: Radar
- K: Kamera
- SG: Steuergerät
- GPU1 - GPU3: Grafikprozessor
- FS: Fahrzeug system
- G: Gehäuse
- RS: innere und äußere Rippenstruktur
- F1 - F5: Lüfter
- HP1, HP2: Heatpipe
- GAP1, GAP2: Gapfilter
- LS: Luftstrom
- LK: Luftkanal
- PB1 - PB3: Performance-Board
- CB: Carrier-Board
- AH: Abstandshalter
- LS1 - LS3: Luftströme

## Patentansprüche

1. Steuergerät (SG) für ein Fahrzeug (V) mit:
- wenigstens einem Elektronikbaustein (GPU)
- wenigstens einem ersten Lüfter (F1)
- einem Luftkanal (LK), der einen Luftstrom (LS) von einer ersten Seite des wenigstens einen Elektronikbausteins (GPU) zum ersten Lüfter (F1) ermöglicht, wobei der Luftstrom (LS) an einer zweiten Seite des wenigstens einen Elektronikbausteins (GPU) vorbeiströmt.

2. Steuergerät nach Anspruch 1, **dadurch gekennzeichnet, dass** wenigstens ein erstes Wärmerohr (HP2) im Bereich des Luftstroms (LS) an der zweiten Seite des wenigstens einen Elektronikbausteins (GPU) vorgesehen ist.

3. Steuergerät nach Anspruch 2, **dadurch gekennzeichnet, dass** an der ersten Seite des wenigstens einen Elektronikbausteins (GPU) wenigstens ein zweites Wärmerohr (HP1) vorgesehen ist.

4. Steuergerät nach Anspruch 3, **dadurch gekennzeichnet, dass** zwischen dem wenigstens einen Elektronikbaustein (GPU) und jeweils dem ersten und dem zweiten Wärmerohr (HP1, HP2) ein Gapfiller (GAP) angeordnet ist.

5. Steuergerät nach Anspruch 4, **dadurch gekennzeichnet, dass** der wenigstens eine Elektronikbaustein (GPU) auf einer Performanceplatine (PB) angeordnet ist, wobei die Performanceplatine (PB) auf einer Trägerplatine (CB) angeordnet ist.

6. Steuergerät nach Anspruch 5, **dadurch gekennzeichnet, dass** mehrere Performanceplatinen (PB1 bis PB3), die auf der Trägerplatine (CB) angeordnet sind, vorgesehen sind, wobei der Luftkanal (LS1 bis LS3) in Abhängigkeit vom jeweiligen Elektronikbaustein (GPU) gestaltet ist, um einen entsprechenden Luftstrom (LS1 bis LS3) zu erzeugen.

7. Steuergerät nach einem der vorhergehenden Ansprüche, **dadurch gekennzeichnet, dass** wenigstens ein zweiter Lüfter (F2) außerhalb eines Gehäuses (G), das den wenigstens einen Elektronikbaustein (GPU), den wenigstens einen ersten Lüfter (F1) und den Luftkanal (LS) umschließt, angeordnet ist.

8. Steuergerät nach Anspruch 7, **dadurch gekennzeichnet, dass** das Gehäuse (G) außen wenigstens teilweise eine erste Rippenstruktur (RS) aufweist.

9. Steuergerät nach Anspruch 8, **dadurch gekennzeichnet, dass** das Gehäuse (G) wenigstens teilweise innen eine zweite Rippenstruktur (RS) aufweist.

10. Steuergerät nach einem der Ansprüche 7 bis 9, **dadurch gekennzeichnet, dass** der wenigstens eine erste Lüfter ein Radiallüfter ist oder/und der wenigstens eine zweite Lüfter (F2) ein Axiallüfter ist.

11. Steuergerät nach Anspruch 1, **dadurch gekennzeichnet, dass** das Steuergerät mit Stickstoff befüllt ist.

12. Steuergerät nach einem der Ansprüche 6-11, **dadurch gekennzeichnet, dass** zwischen den Performanceplatinen unterseitig Wände vorgesehen sind.

13. Steuergerät nach Anspruch 9, **dadurch gekennzeichnet, dass** die Rippenstruktur zueinander parallele Elemente aufweist.

14. Steuergerät nach Anspruch 10, **dadurch gekennzeichnet, dass** der Radiallüfter thermisch mit dem Gehäuse verbunden ist.
